## Europäisches Patentamt

## European Patent Office

## Office européen des brevets

(11) Publication number: **0 319 519**
**A2**

# EUROPEAN PATENT APPLICATION

(21) Application number: **89100925.0**

(22) Date of filing: **27.10.87**

(51) Int. Cl.⁴: **H 05 K 7/14**
**G 06 F 13/40**

(30) Priority: **20.03.87 US 25101**

(43) Date of publication of application:
**07.06.89 Bulletin 89/23**

(84) Designated Contracting States:
**AT BE CH DE ES FR GB GR IT LI LU NL SE**

(60) Publication number of the earlier application in
accordance with Art. 76 EPC: **0 282 637**

(71) Applicant: **International Business Machines
Corporation
Old Orchard Road
Armonk, N.Y. 10504 (US)**

(72) Inventor: **Dusi, Samuel Thomas
984-5 Pineapple Tree Drive Apt 208
Boynton Beach Florida 33336 (US)**

**Escobar, German
401 Denny Court
Boca Raton Florida 33432 (US)**

**Heath, Chester Asbury
681 N E 30th Place
Boca Raton Florida 33431 (US)**

**Kirk, Richard Dana
430 S W 5th Avenue
Boynton Beach Florida 33435 (US)**

**Manns, Kenneth Lynn
2558 N W 32nd Street
Boca Raton Florida 33434 (US)**

**Moore, Billy Williams
1935 S W 7th Court
Boca Raton Florida 33433 (US)**

**Shaw, Richard William
332 S.W. 80th Terrace
North Lauderdale Florida 33068 (US)**

**Zaderej, Victor Vasyl
275 N.E. 4th Street
Boca Raton Florida 33432 (US)**

**Neer, Jay Henry
6510 Casabella Lane
Boca Raton Florida 33433 (US)**

(74) Representative: **Hawkins, Anthony George Frederick
IBM United Kingdom Limited Intellectual Property
Department Hursley Park
Winchester Hampshire SO21 2JN (GB)**

(54) **Computer system accepting feature cards.**

(57) A computer system accepting feature cards for, for
example, coupling external peripheral devices includes a
plurality of sockets mounted on the planar board to accept
edge connectors on the cards, and slots in the main enclosure
to permit coupling to external peripherals. To reduce electro-
magnetic radiation, the slots in the main enclosure have a depth
such as to define channels, and the brackets on the cards are of
U-shaped cross-section such as to fit within the channels. The
channel walls are conductive, and the brackets are shaped to
define spaced outward contact points which closely engage the
channel walls.

FIG. 8

EP 0 319 519 A2

**Description**

## COMPUTER SYSTEM ACCEPTING FEATURE CARDS

The present invention relates to computer systems, and in particular to means for minimising electromagnetic radiation from such systems.

In the prior art personal computer systems, a planar board containing the processor logic is positioned by mating pins and holes to the base of a sheet metal frame also having side walls. One section of the side walls includes an inwardly extending sheet metal shell (often referred to as a "shadow box") welded thereto and having vertical slots to permit connection of I/O feature cards within the frame to external peripheral units via cables and I/O connectors. The cards are connected electrically and mechanically to the board via card/board connectors inserted into the board and lower contact tabs on the cards forced into the card/board connectors. Low carbon steel I/O brackets connected to the cards are adapted to engage the shell and cover the vertical slots, a screw securing the upper end of the bracket to the shell and a contact spring forcing the lower end of the bracket against the shell. Similar brackets are attached to the shell in slot positions not having feature cards.

This prior art configuration has several disadvantages. The location of the installed card/bracket assembly in the direction of shell is established primarily by the engagement of the card tab in its associated connector in the system board. The dimensional relationship between the adjacent surfaces of each bracket and slot is established by tolerance variations in a number of dimensions, such as the distance between the card tab and holes through which threaded fasteners operate to fasten the bracket in place, the distance between the holes in a card bracket through which these fasteners operate and the surface of this bracket adjacent to the shell, the distance between this surface of the shell and fasteners which attach the system board in place in the frame, the distance between the holes for these fasteners operating in the system board and the holes used to locate the card/board connector in this assembly, the location of the pins extending from this connector within the holes in the system board, and the squareness of the shell with respect to the surfaces of the frame on which the system board is mounted.

Because of the large number of dimensions involved, relatively large variations in this distance between the adjacent surfaces of the I/O bracket and slotted surface of the shell occur in the process of manufacturing system units. If this distance is too large, the bracket is warped during installation so that a substantial gap exists between these surfaces. In other words the contact spring and screw hold the lower and upper portions of the bracket against the surface of the shell, but the connection of the card to the board pulls the central portion of this bracket away from the adjacent surface of the shell. This warping presents an obvious visual problem when the system unit is viewed from the rear and establishes slots through which electromagnetic radiation can escape from the unit.

Grounding electrical contact between the bracket and the shell is established only at top and bottom. This is a particular disadvantage because cable connectors are typically fastened to such card brackets in their central regions, so that the electrical resistance of the brackets along their length becomes a part of the high-frequency resistance between such connectors and the frame. This resistance makes it more difficult to control the electromagnetic radiation of cables attached to such connectors and acting as antennas.

On the other hand, if there is a mechanical interference between the adjacent surfaces of bracket and the shell, the frame must be deflected to allow the installation of the card assembly. This condition can make such installation difficult or impossible, causing a serious problem in the manufacturing or field environment and causing stress in the feature cards.

The engagement of the contact spring with a blank bracket often establishes a torque on the bracket so that the central region of this bracket is warped away from the adjacent surface of the shell, also presenting a visual problem when the unit is viewed from the rear and establishing slots through which electromagnetic radiation can escape from the unit.

Such problems make it difficult to maintain EMC integrity below the FCC Class B limit at clock frequencies greater than 8 mhz. It is therefore a primary object of the present improvement to an arrangement which obviates the disadvantage of this prior art configuration.

According to the present invention, there is provided a computer system comprising a housing having an electrically conductive surface, and slots in the housing for accepting electrically conductive brackets, each said slot having a pair of opposed longitudinally extending walls, and each said bracket comprising comprising a channel with a pair of side walls spaced and shaped for engagement with said opposed walls of a slot to make electrical contact therewith.

In an embodiment of the invention to be described in detail later, a shadow box is moulded directly into the rear wall of the base frame of a processor unit, the frame being moulded from polycarbonate and the interior surfaces being plated with nickel and copper.

Each of the vertical slots in the shadow box, through which connections are made to peripheral devices, is defined by a generally U-shaped channel structure, the slot being an opening in the rear wall of the channel structure leaving only a ledge for the rear wall. A mating U-shaped I/O bracket is adapted to be received within each channel. This design permits an increase of as much as 30% in the width of I/O connectors received in the channel and bracket.

By moulding in the shadow box, the cost, inventory and installation requirement of additional parts is eliminated. Additional room is provided for a larger selection of connectors to be utilised in the I/O bracket and tolerance build up between the feature cards and the enclosure are reduced.

This moulded plastic design in conjunction with improved I/O bracket provides continuity every half inch for improved cable shield termination and overall enclosure shield integrity. The reduction of shield integrity between a separate shadow box and frame has been eliminated. As will be seen below, the requirement of tools to install and remove feature cards has been eliminated. The I/O bracket is held securely in place by a tab stamped into the I/O bracket, which requires no tool for installation.

When installed, the I/O bracket has the freedom to float, without loss of EMC integrity, from front to back in the unit. This float allows for tolerance accumulation which occurs between the base, planar and I/O port, and prevents stress concentrations from forming on the feature card.

The shadow box . frame design is preferably formed by moulding all internal features of the shadow box into the internal core of the tool requiring the vertical support walls be tapered by about 0.5 degrees. The tool for this method is less expensive to build and easier to maintain. The I/O bracket would have corresponding 0.5 degree taper, which when installed and removed causes less wear and degradation to the plating on the base.

The I/O bracket has a "U Channel" structural shape formed from half-hard stainless steel. This provides strength to the relatively thin material thickness required for the bracket to act as a spring along its side walls where EMC contacts are stamped into it. This material does not require any secondary plating or finishing and the brackets can be used as they are produced from the die.

The bracket has incorporated EMC grounding contact points approximately every 12mm all around the periphery of the bracket to approximate a 360 degree connection of an external cable shield to frame ground and to provide the required cabinet shield continuity across the option slot. The configuration of these contacts is unique in that they are a type or torsion spring. These springs accommodate the different shadow box manufacturing tolerance requirements imposed by the different materials used for manufacturing various system units. The spring also provides controlled pressure to plated plastic surface of shadow box so as to control insertion and removal forces and erosion of the plated surfaces.

The contact configuration is such that the bracket may be installed either straight down into the shadow box so that the contacts slide down the side walls of the shadow box until the bracket is seated. They may also be installed from any angle behind the opening and will conform to the side walls of the shadow box without catching or hanging up on the corners/edges of the box causing damage to either the box or the bracket.

The bracket design eliminates the need for any internal attachment screws. Product safety requires that the bracket provide a substantial path to frame ground in the event that an external feature/attachment fails and produces an electrically unsafe condition at the bracket. As a result, an external captive thumb screw is received through a slot at the bottom of the bracket and secures the bracket to a ground stud.

The brackets are attached to the option cards with two pop rivets. Two tabs formed along one side, one at the top and the other at the bottom provide a maximum support span. Each tab has an embossed diameter with a clearance hole through it. The rivets pass through the holes in the bracket and corresponding holes in the card. A mandrel pulled though the centre of the rivet expands the rivet, centring the parts to the holes and clamping them together simultaneously. The rivets also reduce tolerance accumulation, provide a good conductive path, reduce the fasteners required and can be assembled on an automated production line. The tabs are embossed to keep the head of the rivet within the minimum width of the bracket. This prevents interference between the rivet head and the shadow box. The embossed diameters are formed to different depths to enable the card to remain at a 90 degree position relative to the planar board while matching with the moulding draft angle in the shadow box. These holes/locations are standardised so that as new option cards are developed, the only tooling that may be required is a new insert for the progressive die for the I/O connector(s).

The two tabs/outriggers on each side at the top of the bracket serve multiple functions:

They provide a maximum down position stop (in conjunction with guide posts) so that the option cards will not tilt and cause shorting across the connector/card tab system.

The tabs provide for system security because they fit behind the guide posts moulded into the base such that intruders must physically force and damage the brackets before they can gain entrance to the system bus.

They provide the main datum/reference plane for the bracket tooling.

They provide the primary reference plane between the I/O bracket, feature card assembly and the planar board.

A spring finger is formed at the top of the bracket between the outrigger tabs to provide an EMC ground contact with the conductive surface of the shadow box.

The I/O bracket is designed for all option cards, irrespective of the I/O connector type and size required. Through the use of inserts in the tooling, the myriad of I/O connectors required in the future will be able to be handled in the same tool for stamping out the brackets. The improved configurations described herein have the following advantages over prior art configurations:

    1. The slot configuration is adapted so that it can easily be moulded into a plastic framework;

    2. The bracket is configured so that it makes electrical contact with the slot at a number of points by means of spring loaded surfaces as well as in an area under a threaded fastener;

    3. The bracket and slot are configured so that the multiple contact pattern is not disturbed by displacement of the bracket in the direction of the length of the card due to variations in the dimensional tolerances of the card and of the planar board assembly into which the card is plugged; and

4. The shape of the bracket and the direction of application of contact forces are chosen to prevent warping of the bracket during installation, thereby improving both the appearance of the unit and the electrical grounding of the bracket.

Multiple point contact with a minimised distance between contact points helps reduce electromagnetic radiation from the unit. The minimised distance between contact points minimises the reflection of electromagnetic radiation through any slot which may exist between the bracket and the framework and minimises the effect of induced voltage patterns at high frequencies on the bracket. Furthermore, multiple grounding points are used to increase the effect of electrically grounding the bracket at high frequencies so that an improvement can be expected in the electrical grounding of any cable connector which is attached to the bracket. This latter effect is especially important due to the fact that improperly grounded and shielded cables attached to such connectors tend to radiate as antennas.

As described in greater detail below, the mechanical arrangement of the frame, I/O bracket, board/card connector, feature card and planar board and their mechanical, electrical interconnection permits the distances between contact centres in the board/card connector to be reduced by as much as fifty percent. In addition, the number of ground lines/contacts in this connector have been reduced by three fourths without significantly increasing electromagnetic radiation. The combination of these improvements significantly reduces the size of the board/card connector.

The preferred embodiment of the invention will now be described in detail with reference to the accompanying drawings, in which:

Figs. 1, 2, and 3 are elevation, plan and sideviews of one embodiment of a shadow box;

Figs. 4 and 5 are a perspective view of one form of an I/O bracket and a plan view of the bracket blank after it has been stamped out but before it is fully formed for use in covering an empty socket;

Figs. 6 and 7 are similar perspective and plan views of another form an improved I/O bracket adapted for connection to a feature card;

Fig. 8 is a fragmentary perspective view illustrating a shadow box generally of the type shown in Fig. 1, secured within a computer enclosure, and a feature card being inserted into a board/card connector;

Fig. 9 is a exploded perspective view of a feature card, one form of the improved I/O bracket, preferred forms of card retainer and card holder and the means for fastening the elements together;

Fig. 10 is a fragmentary perspective view of the shadow box moulded into the computer unit frame as an integral part thereof and the preferred forms the improved I/O brackets;

Figs. 11, 12, and 13 are plan, sectional elevation and sectional side views of a board/ card connector;

Fig. 14 is a diagrammatic illustration of the pin arrangement of Fig. 13 to explain electromagnetic radiation therefrom; and

Fig. 15 diagrammatically illustrates the improved arrangement of ground and signal lines coupled to the contacts in the card/board connector of Figs. 11-13.

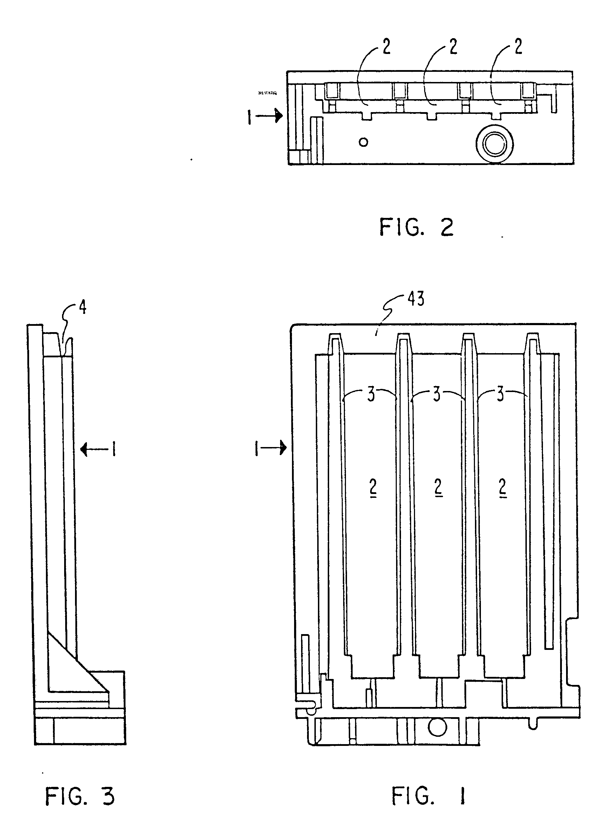

Figs. 1 to 3 show a shadow box 1 with three vertical slots 2 in the form of U-shaped channels. Flange surfaces 3 are formed at the rear of each channel and the channels are tapered from top to bottom (Fig. 1) with a .5 degree draft. Notches 4 (Fig. 2) are formed at the upper ends of the channel. The box 1 is preferably moulded of polycarbonate material and all forward and side surfaces are metal plated, preferably with copper and nickel.

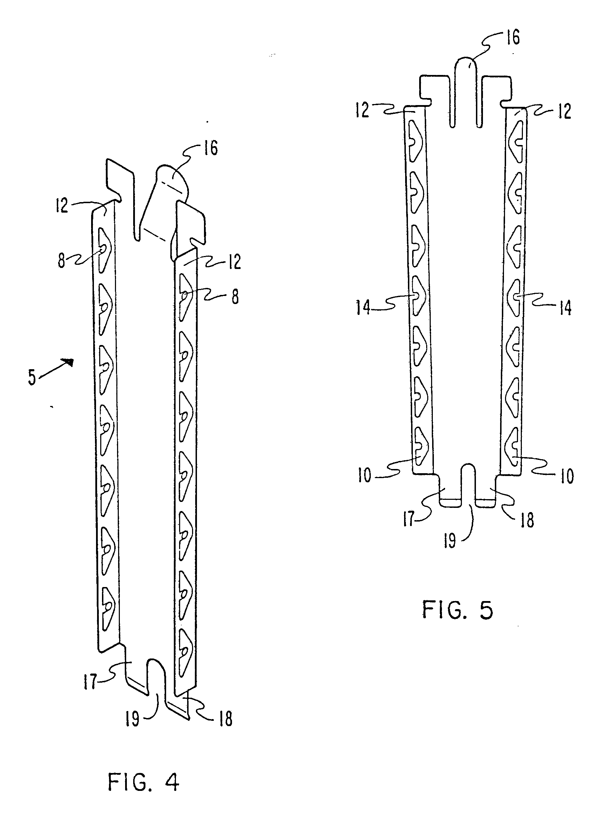

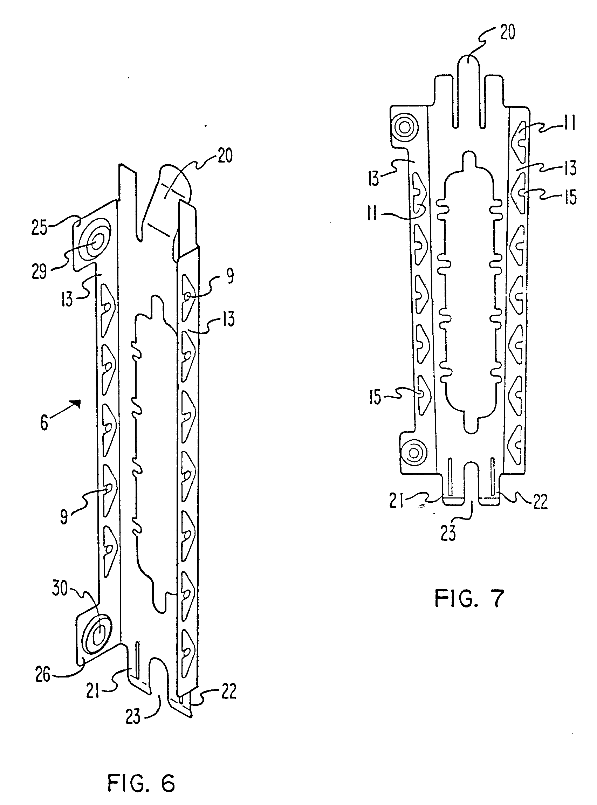

The I/O brackets 5 and 6 (Figs. 4 and 6) are each fabricated from stainless steel with a U-shaped cross-section for insertion within one of the channels 2. The brackets 5 and 6 are also tapered from top to bottom with a .5 degree draft so that, as they are slid into channels 2 from top to bottom, a clearance exists between the bracket and channel sides and wear on contacts 8 and 9 is minimised until the I/O bracket is firmly seated within the channel.

When the brackets 5 and 6 are initially stamped out into blanks (Figs. 5 and 7), small triangular cutouts 10 and 11 are made in the side sections 12 and 13 of brackets. Projections 14 and 15 are subsequently dimpled to form the outwardly extending contacts 8 and 9 which act in a cantilever fashion for reliable electrical connection when they engage the vertical side walls of the channels 2. The contacts are preferably spaced about 12mm apart to minimise electromagnetic radiation around the bracket 5 or 6 and through the channels 2. A spring loaded tab 16 is formed at the upper end of bracket 5 and tabs 17 and 18 are formed at the bottom, defining a slot 19. Bracket 6 has similar tabs 20, 21, 22, and slot 23.

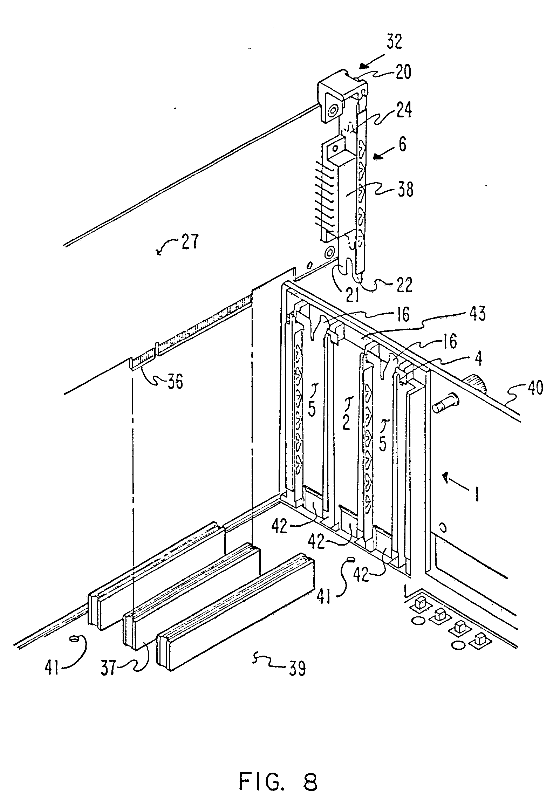

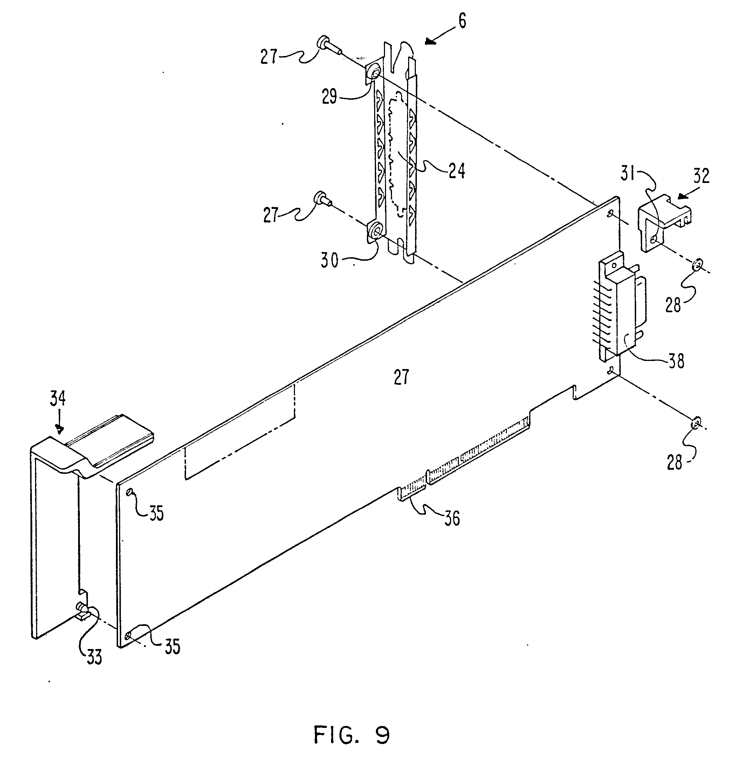

One or more openings such as that shown at 24 (Fig. 7) are provided in bracket 6 to receive I/O cable plug assemblies (not shown) therethrough. Tabs 25 and 26 of bracket 6 are provided for connection to a feature card 27 (Figs. 8 and 9). Bracket 5 has no opening 24 nor tabs 25 and 26, because it is intended to cover a channel 2 through which no connection to an external peripheral device is made.

Fig. 9 illustrates a preferred form of the feature card assembly including the card 27, the bracket 6 attached to the card by fasteners in the form of rivets 27 and washers 28. The rivets 27 are received through holes 29 and 30 in the embossed areas of the tabs 25 and 26 of bracket 6 and the upper rivet is also received through a hole 31 in a card holder 32 to tightly and accurately (as described above) connect the bracket 6 and card 27 to the holder 32. The rivet heads are enclosed by the embossed areas as described above in greater detail.

Upper and lower snap pins 33 on a card retainer 34 secure the retainer to the card 27 when they are pressed through holes 35 in the card. Card 27 also has a tab 36 with conductors on either side thereof and intended to be received within a mating connector such as that shown at 37 (Fig. 8). External connections to a peripheral device are made through a socket 38 carried by card 27.

Fig. 8 illustrates the bracket 6 about to enter channel 2 of shadow box 1 as card 27 is lowered to force tab 36 into connector 37. Pins (not shown) on the lower edge of the connector 37 have previously been forced into mating holes (not shown) in the planar logic board 39. The board 39 is accurately positioned on the base of a computer frame 40 by means of mating positioning holes and pins shown at 41. The shadow box 1 is suitably secured to and positioned within the frame 40 relative to the board 39. Shield grounding studs 42 are adapted to make firm mechanical and electrical shield contact with tabs such as 17 and 18 (Fig. 4) of bracket 5 and tabs 21 and 22 of bracket 6 to the shield ground system. Upper tabs 16 and 20 of the brackets engage the plated surface of the upper cross member 43. Tabs 50 in brackets 5 seat within notches 4 to retain the upper ends of the brackets in place. The shield ground system (not shown) is distinct from the logic ground system. This isolation prohibits logic signals from returning via the shield to A.C. safety ground through external equipment. The large area defined by such an external loop can, by equation 1 below, imply significant high frequency RF radiation even with very small currents through the loop.

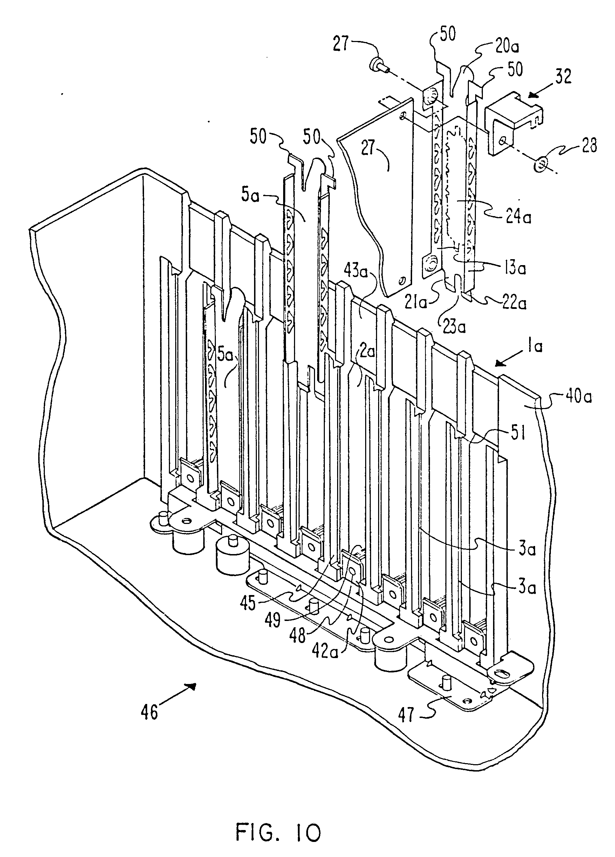

Fig. 10 shows the preferred embodiment of the shadow box 1a integrated directly into the frame 40a. When the card 27 assembly is installed in the shadow box 1a, card bracket 6a operates in an associated slot 2a of machine frame 40a, which is a plastic structure plated with copper and nickel to assure electrical conductibility between the bracket and frame. The card bracket 6a includes a rear surface 44, which essentially closes slot 2a of the machine frame when a card assembly for internal logic is installed. If the circuit on card 27 is connected to devices external to the system unit, a cable connector (not shown) is mounted through an appropriate hole 24a in this rear surface. Such connectors are generally also electrically grounded to this rear surface. The card bracket 6a additionally includes a pair of side surfaces 13a, which slide adjacent to frame surfaces 45 on either side of the channel 2a. Each of these side surfaces 13a includes five contact points 9a. Each contact point is supported in position by cantilever spring action. These surfaces, contact points, and cantilever springs are stamped and formed from a single sheet of stainless steel. The ten contact points 9a contact adjacent areas of the frame surfaces 45, providing a distributed multiple-point grounding function which is desirable to aid in the control of electromagnetic radiation. The cantilever spring action is configured so that this contact occurs regardless of dimensional variations in the card bracket 6a and the frame 40a. Because the side surfaces 13a are parallel to the direction of arrow 46, the overlapping provided with respect to frame surfaces 45 is maintained, so that this contact is maintained, regardless of the effect of allowable tolerance variations in the direction 46 in locating the card 27 by means of tab 36 (Fig.8).

Frame surfaces 45 are slightly angled with respect to each other to provide a tapered opening which is widest at its entrance during the installation of a card assembly. This is done to allow the withdrawal of the die section which forms this part of the plastic frame 40a. Side surfaces 13a of the card bracket are similarly angled slightly with respect to each other to provide uniform engagement when the card assembly is fully installed. This tapering of the profile of the opening and of the card bracket also aids in the installation or removal of the card assembly by eliminating the requirement for full deflection of the cantilever springs during the installation process.

Card bracket 6a also includes an upper end tab 20a which contacts an adjacent frame surface 43a when the card assembly is installed, and lower end tabs 21a and 22a which contact the reverse surface of stud 42a of a grounding bracket 47. This grounding bracket 47 is electrically connected to the electrical ground of the machine by a suitable A.C. coupling means not shown. The ends of tabs 21a, 22a and the stud 42a are formed away from each other to aid in the installation of the card assembly by preventing end-to-end contact.

Tabs 21a and 22a include a slot 23a, which allows this tab to pass by threaded stud hole 48 which receives a captive threaded fastener 49, which is threaded at one end and knurled at the other. This fastener 49 can be tightened by hand to clamp tabs 21a and 22a after the installation of the card assembly. This clamping provides an electrical grounding path which is capable of carrying relatively high currents to assure that current protection devices will be activated in the event of a short circuit involving hardware attached to the card bracket.

Blank brackets 5a are provided to close unused slots in the frame. These brackets engage the surfaces of the frame 40a and of the studs 42a associated with grounding bracket 47 as described above. In addition, a pair of tabs 50 operate in adjacent notches 51 in the frame 40a to hold the upper end of each bracket 5a in place when it is installed. Similar tabs 50 are also provided on bracket 6a and also prevent the card 27 from tilting too much.

The frame 40a also includes flange surfaces 3a, which serve an aesthetic purpose in blocking the contact areas from view from the outside of the rear of the unit, controlling air flow for cooling and which further prevent electromagnetic radiation outside the unit.

Since contact surfaces 45 are parallel to the direction of arrow 46, and since contacts 9a are configured to make electrical contact with these surfaces, this contact will be achieved regardless of the variations in the location of the card assembly in the direction of arrow 46 caused by the engagement of card tab 36 with the system board connector 37 as illustrated in Fig. 8. Such variations can be expected to occur due to variations in dimensional tolerances within the card assembly, the frame, and the system board. This contact engagement is furthermore achieved without warping the main structure of the card bracket 6a. Since the cross-section of this bracket 6a is "U" shaped, this structure is stiff and resistant to warping. Since a multitude of contact points are provided around the periphery of the card bracket 6a, the distance between adjacent points is limited, minimising the length of any slot through which electromagnetic radiation can escape. Since the contact points are flexibly configured with respect to the main structure of the card bracket 6a, electrical contact can be easily achieved at all points regardless of the variation of dimensions within tolerances.

In future personal computers, it will be desirable to provide in one size box different processor capabilities with for example an 8 or 16 bit data bus, 24/32 bit address bus, for single or multiple bus small computers with different but compatible processors. This offers a base upon which to build a plurality of small systems that extend above and below the Personal Computer market.

Conservation of space in the frame and superior EMC characteristics are important in these future systems. In such systems, signals originating from the processor clock and a system oscillator are provided on one or more asynchronous buses. The signals are used to generate other high speed signals both by circuits on the planar board such as 39, Fig. 8 and on feature cards such as 27. Even when the processor clock on the bus is a sub-multiple of the actual clock used to step the processor, transitions on the bus stimulated by the processor generate frequency components that are harmonics or mixing products of the true processor clock. It is well known that the electromagnetic (EMC) radiated field is produced by the aggregation of all the radiating current loops in the system. True progress in optimising EMC can be gained in a system by eliminating cables, controlling rise times, decoupling, and other examples of good design practice. Without solving the radiation problem at its source, however, good design practice can involve expensive solutions such as filtering, plating of the chassis and power supplies and shielding. The radiation emanating from the connector between the system board and a feature card can be diminished significantly with the techniques described below.

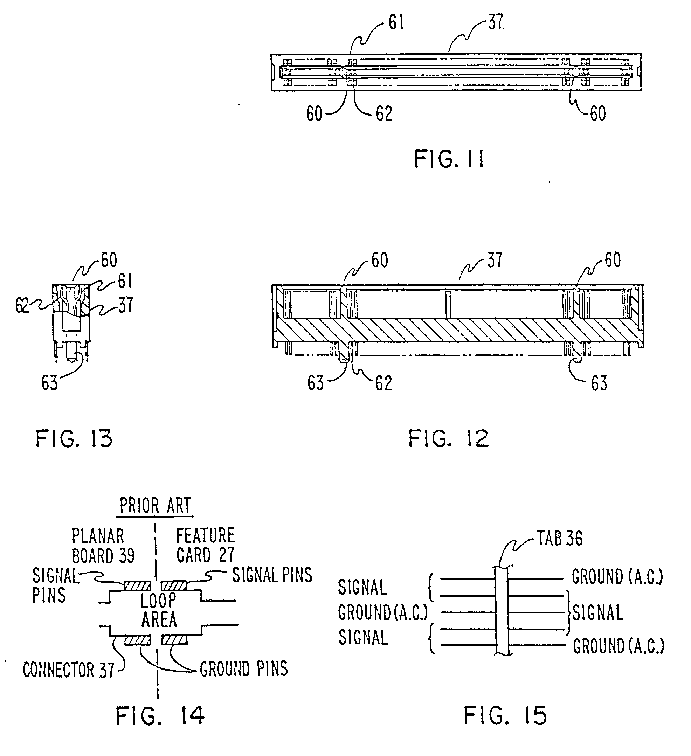

Testing in any EMC chamber has shown that input/output (I/O) connectors are the primary source of EMC radiation even when the system appears only with the attachment of external equipment. This occurs because current loops are introduced by the processor clock and other high frequency signals when they enter and return from an I/O feature card. Ground planes in the planar and feature cards will eliminate the current loops there but the radiating signals are exposed as they pass through the feature card connectors. The radiated energy is determined by the following equation, reference being directed to Fig. 14:

EQUATION 1: $E = KAIF^2$

WHERE:

E is the radiated field vector
K is a proportioning constant
A is the area of each loop
I is the current in the loop
F is the component of frequency generating the energy

The net of this is that the energy radiated is controlled by three factors, loop area, current and frequency. In addition, the problem gets worse as the square of the processor clock. The frequency is dictated by the processor speed chosen in the design and the current is dictated by the current of logic receivers and drivers located on feature cards. The loop area is determined by the distance of the signal to the nearest ground and the physical dimensions of the connection such as 37, Fig. 8. Given that a 6 mhz processor is 6db below the FCC class B limit, then this equation correctly predicts that an 8 mhz clock in the same clock in the same processor would be 1db below the FCC class B limit at the analogous frequency or harmonic. Furthermore, without further efforts at containing the radiation, the FCC limit would be exceeded for the processor operating with a clock above 8.5 mhz. One experimental grounding system, using an improved pin arrangement and other EMC features described herein, has tested at 20db of margin for processor generated components indicating a cutoff by the preceding method at approximately 30 mhz.

The ground return current is predominately through the preferred path due to the lowered impedance provided by the mutual inductance to the adjacent signal conductor. In a cable a separate ground is usually associated with each signal in order to assure mutual inductive coupling "M" to one path only when a significant inductance "L" (diluting the effect of "M") may be in series with the grounds to single point ground connections at cable ends.

If the series inductance "L" is minimised by standard techniques such as ground planes at cable ends or gridded ground systems or the like then a common ground return for a number of signals 1, 2, N may be employed with the mutual inductances being dominant factors controlling current path selection. The area defined by the space between signal and ground is therefore minimised if the ground return is adjacent to all signals involved.

The improved pin arrangement of Fig. 15 minimises radiated emissions:

    a. Every fourth pin on each side of the feature card edge connector 36 (Fig. 8) is connected directly to ground or decoupled to ground at radio frequency (A.C. ground) as shown in Fig. 15. Connector 37 pins are therefore similarly connected.

    b. The A.C. ground pins on one side of the edge connector are offset by two pins from those on the other side. This results in a symmetrical grounding pattern where no signal is more than one pin spacing from an A.C. ground.

    c. The symmetrical A.C. ground arrangement tends to cancel fields radiated by a signal relative to two grounds.

    d. Signals that are switched simultaneously on the bus are arranged with one half of the signals on one side of the card tab 36 and the connector 37 and one half on the other side in close proximity to one another. This encourages cancellation of fields. This is done with the address bus as well as the data bus.

e. Signals with fast rise times of high frequencies are arranged adjacent to A.C. grounds.

f. The connector 37 is miniaturised to one half of the pin to pin spacing of known connectors to further reduce the loop area.

g. The audio system signals utilise a separate ground (not shown) to minimise coupling of digital and audio information. This ground is connected to the digital signal ground at a single point.

h. All current is returned through the connector grounds only and not through the rear bracket connector or cable lines.

Note that a reduction in the loop area by a factor of four is required to offset a doubling of frequency. Many of the design changes made to achieve the above improvement also improve the wireability and manufacturability of cards and planars.

One preferred form of the connector 37 is shown in Figs. 11-13; longer connectors with a greater number of pins can now be used in the space assigned in earlier systems to connectors with far fewer signal pins. One or more alignment pins 60 within connector 37 are adapted to be received within mating structures (not shown) in tab 36 of a feature card when inserted into connector 36. These pins 60 are important to minimising tolerances and permitting closer distances between centres of contact pins on the card, board, and connector and for preventing shorting between pins in connector 37 by contacts on tab 36 if the card 27 is tilted too much from one end of tab 36 to the other. The tabs 50 on bracket 6a (Fig. 10) seating within notches 51 also help to prevent shorting between adjacent pins on connector 37.

Contact lines on opposite surfaces of the tab 37 engage opposed contact wires or pins 61 and 62 within connector 37 and opposite ends of the pins 61, 62 project below the connector 37 for receipt within plated-through holes (not shown) in the planar board 39 (Fig. 8).

Alignment pins 63 projecting from the bottom of connector 37 are received within mating alignment holes (not shown) in the board 39 to properly align the connector and guide the insertion process.

**Claims**

1. A computer system comprising a housing having an electrically conductive surface, and slots in the housing for accepting electrically conductive brackets, each said slot having a pair of opposed longitudinally extending walls, and each said bracket comprising a channel with a pair of side walls spaced and shaped for engagement with said opposed walls of a slot to make electrical contact therewith.

2. A computer system according to claim 1 in which said side walls are shaped to define resilient projections which extend outwardly therefrom to engage the slot walls by point contact.

3. A computer system according to claim 2 in which said side walls have apertures with areas into which said resilient projections extend.

4. A computer system according to claim 1 or claim 2 in which the slots are tapered longitudinally from one end towards the other end, and the brackets are tapered to correspond with the slot taper to assist insertion of a bracket into a slot.

5. A computer system according to any one of the previous claims in which each bracket includes, at one end thereof, an aperture for engagement with a threaded stud mounted on the housing when the bracket si positioned within a slot, whereby the bracket is clamped to the housing by tightening the stud on to the bracket.

6. A computer system according to claim 4 in which each bracket includes, at the end opposite to said one end thereof, an outwardly extending resilient arm and a pair of tabs adjacent the arm, and the housing has a pair of notches adjacent each slot for engaging said tabs to force the arm into pressure contact with the housing surface.

7. A computer system according to any one of the previous claims including ears on one side of the walls of a bracket, said ears projecting outwardly from, and in the same plane as, this side wall, for fastening a computer feature card to the bracket.

8. A computer system according to claim 6 including an aperture in the bracket for accepting a feature card connector.

9. A computer system according to any one of the previous claims in which said housing is formed from a plastics material having a plated coating forming said electrically conducting surface which extends over the side walls of the slots.

10. A computer system according to any one of the previous claims in which each bracket is unitarily constructed from a metal having a thickness such as to exhibit resilience.

FIG. 2

FIG. 3

FIG. 1

FIG. 4

FIG. 5

FIG. 6

FIG. 7

FIG. 8

FIG. 9

FIG. 10

FIG. 11

FIG. 13

FIG. 12

PRIOR ART

PLANAR BOARD 39

FEATURE CARD 27

SIGNAL PINS

SIGNAL PINS

LOOP AREA

CONNECTOR 37

GROUND PINS

FIG. 14

TAB 36

SIGNAL

GROUND (A.C.)

GROUND (A.C.)

SIGNAL

SIGNAL

GROUND (A.C.)

FIG. 15